# EUROPEAN PATENT SPECIFICATION

(11) **EP 0 790 634 B1**
(45) Date of publication and mention of the grant of the patent: **02.02.2000**
(21) Application number: 96110765.3
(22) Date of filing: 03.07.1996
(51) Int. Cl.: H01J 37/145

(54) **Electrostatic-magnetic lens arrangement**
Elektrostatisch-magnetische Linsenanordnung
Dispositif de lentille électrostatique-magnétique

(30) Priority: 16.02.1996 DE 19605855
(43) Date of publication of application: 20.08.1997
(73) Proprietor: ACT Advanced Circuit Testing Gesellschaft für Testsystementwicklung mbH, 81929 München (DE)
(72) Inventor: Ueda, Koshi, 81825 München (DE); Iwai, Toshimichi, 81825 München (DE); Schönecker, Gerald, Dr., 81549 München (DE); Frosien, Jürgen, Dr., 85521 Riemerling (DE); Feuerbaum, Hans Peter, Dr., D-81739 München (DE)
(74) Representative: Tetzner, Michael, Dipl.-Ing.

(56) References cited:
- EP-A- 0 242 602
- WO-A-91/02374
- GB-A- 2 052 147
- US-A- 5 241 176
- JOURNAL OF VACUUM SCIENCE AND TECHNOLOGY: PART B, vol. 7, no. 6, 1 November 1989, pages 1874-1877, XP000117179 FROSIEN J ET AL: "COMPOUND MAGNETIC AND ELECTROSTATIC LENSES FOR LOW-VOLTAGE APPLICATIONS"

## Description

The invention relates to an electrostatic-magnetic lens arrangement for focusing charged particles with a magnetic lens and an electrostatic lens disposed incorporated into the magnetic lens. The invention further relates to a charged particle beam device with such an electrostatic-magnetic lens arrangement.

An electrostatic-magnetic lens arrangement is known from EP-B-0 242 602, in which there are provided a magnetic lens which generates a rotationally symmetrical magnetic field and an immersion lens which is disposed within the magnetic lens symmetrically with the axis of symmetry thereof and which has at least two electrodes lying at different potentials. The charged particles, for example electrons, are decelerated in the field of the immersion lens from a first energy to a substantially lower second energy. Very good lens properties are produced with a relatively short focal length.

However, in this known lens arrangement the specimens must be disposed very close to the magnetic lens during the measurement. However, this is often no longer possible in the case of high specimens like specimens with ICs and associated sockets. An arrangement of the specimen close to the magnetic lens is also limited by the design of the specimen holder. Since on the one hand the specimen has to be contacted during measurement and on the other hand simple exchange of the specimens must be ensured, a greater working distance with good resolving and imaging properties would be desirable.

A charged particle beam device which provides a single-pole lens for focusing the particles is known from GB-B-1 395 201 or US-A-5 241 176. In contrast to a bipolar lens, in the single-pole lens the magnetic field is essentially generated outside the lens, so that greater working distances can be achieved. Such single-pole lenses are distinguished by relatively good lens properties. However, if such lenses are used in the low voltage range, i.e. at final beam energies of the charged particles of less than 5 keV, preferably below 2.5 keV, the lens properties are too poor for many applications at working distances of more than 5 mm.

WO-A-91 02374 discloses a lens arrangement with a magnetic single-pole lens and an electrostatic lens according to the preamble to claim 1.

The object of the invention, therefore, is to improve the electrostatic-magnetic lens arrangement according to the preamble of Claim 1 as well as the charged particle beam device according to the generic concept of Claim 8 which is distinguished particularly in the low voltage range by a great working distance and good lens properties.

This object is achieved according to the invention by the characterising features of Claims 1 and 8.

When combining a single-pole lens with an electrostatic lens, attention must be paid to ensure that the field generated by the electrostatic lens is not so strong that it alone is sufficient to focus the beam. With the lens arrangement according to the invention working distances of more than 5 mm, particularly between 5 and 30 mm, can be achieved.

The lens arrangement has an additional control electrode which is situated in the beam path between the electrostatic lens and a specimen. This control electrode can be connected to a variable potential in order to be able to adjust the electrical field strength in the region of the specimen. For specimens which are particularly sensitive to charging it is then possible to achieve field cancellation in the region of the specimen.

Further embodiments of the invention are the subject matter of the subordinate claims and are explained in more detail below with reference to the description and the drawings.

In the drawings:

Figure 1 shows a schematic representation of a charged particle beam device according to the invention.

Figure 2 shows a schematic representation of a lens arrangement according to the invention, and

Figure 3 shows a schematic representation of two variants of the single-pole lens.

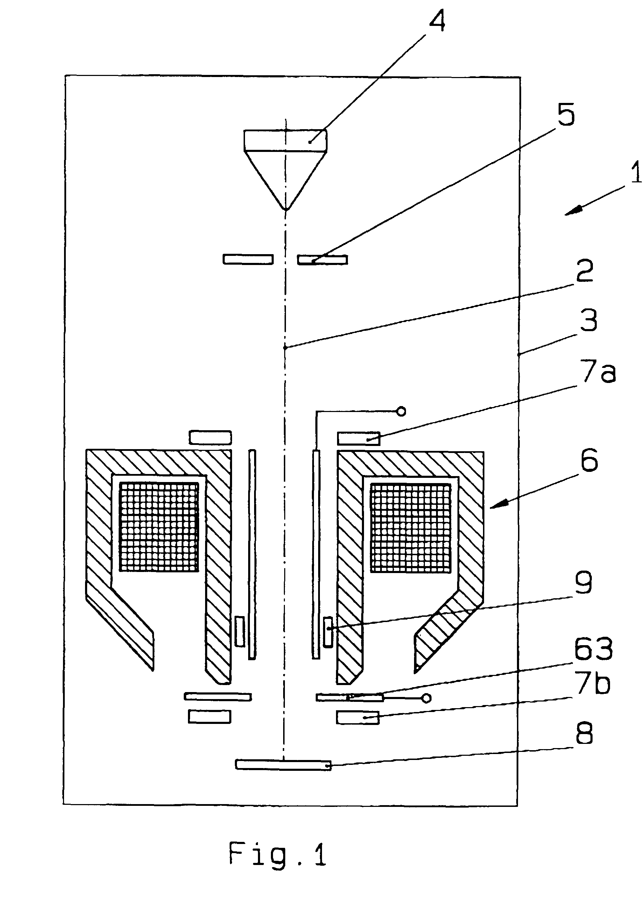

Figure 1 shows a charged particle beam device with which a concentrated particle beam 2, for example an electron beam, can be generated in an optical column 3. In addition to a number of magnetic and/or electrical lenses and diaphragms (not shown here) for beam formation, this column 3 essentially has a source 4 for generating the particle beam 2, a lens arrangement 6 as well as at least one detector 7a or 7b. A blanking system 5 could also be provided for blanking the charged particle beam.

The particle beam 2 generated in the source 4 is focused by the electrostatic-magnetic lens arrangement 6 onto a specimen 8. The particles emitted there pass through the lens arrangement 6 to the detector 7a. However, instead of the detector 7a a detector 7b could also be provided between the specimen 8 and the electrostatic-magnetic lens arrangement 6. To further improve the evaluation of the secondary or the back-scattered particles both the detector 7a and the detector 7b could be provided in a particle beam device. In this case at least one of the two detectors could also be of segmented construction, so that the detector surface is divided into segments the output signals of which can be processed separately from one another.

For scanning the specimen with the particle beam 2 a deflector arrangement 9 is also provided which in the illustrated embodiment is disposed within the lens arrangement 6.

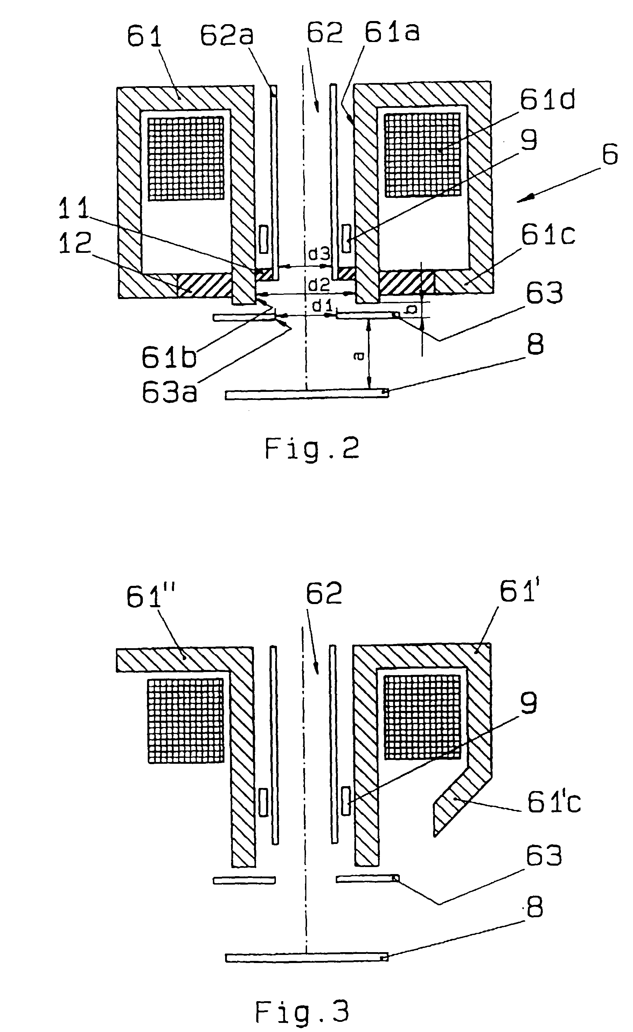

The lens arrangement 6 according to the invention is explained in greater detail below with reference to Figure 2. It consists essentially of a magnetic lens constructed as a single-pole lens 61 as well as an electrostatic lens 62 which is situated within the magnetic lens and generates a rotationally symmetrical electrical field.

This electrostatic lens has two electrodes held at different potentials, and these electrodes can have different potentials applied to them such that the charged particles, for example the electrons, are decelerated in the field of the electrostatic lens from a first energy to a lower second energy. In this case the first energy is 1.2 to 10 times higher than the second energy, in order to achieve the greatest possible working distance with good resolving and imaging properties.

In the illustrated embodiment one of the two electrodes is formed by a cylindrical beam tube 62a which is situated concentrically in an internal bore 61a in the single-pole lens 61. The beam tube 62a is preferably made from non-conductive material which is coated with a thin conductive layer. The second electrode of the electrostatic lens is formed by the lower end of the inner pole piece 61b held at earth potential. However, it could also be provided as a separate electrode. The second electrode does not, however, have to be at earth potential, but can also be set at another potential.

The single-pole lens 61 illustrated in Figure 2 has an inner pole piece 61b as well as an outer pole piece 61c which are of essentially cylindrical shape. A field coil 61d is provided for excitation of the magnetic lens.

An additional control electrode 63 is provided in the beam path between the electrostatic lens 62 and the specimen 8 and is connected to a variable voltage source, which is not shown in greater detail, in order to be able to adjust the electrical field strength in the region of the specimen. The voltage on the control electrode can for example be adjusted between -100 V and +100 V.

The deflector arrangement 9 is preferably constructed as a single-stage deflector arrangement and provided between the beam tube 62a and the wall delimiting the internal bore 61a of the single-pole lens 61.

The charged particle beam device also has a vacuum facility for generating a vacuum in the region of the particle beam. In order to be able better to dissipate the heat generated by the deflector arrangement a seal 11 is preferably provided between the beam tube 62a and the single-pole lens 61 so that the deflector arrangement 9 is surrounded by air and thus an improved heat dissipation is ensured. Equally advantageously, a further seal 12 can be provided in the single-pole lens 61 to shield the field coil 61d from the vacuum.

With the aid of the electrostatic lens 62 the charged particles are decelerated to a final beam energy of lower than 5 keV, preferably between 0.5 and 2.5 keV, a working distance of more than 5 mm being produced between the specimen 8 and the lens arrangement 6. The working distance a is formed here by the distance between the specimen 8 and the control electrode 63.

According to the invention the distance between the control electrode 63 and the specimen 8 (= working distance a) is at least three times the distance b between the control electrode 63 and the single-pole lens 61. The control electrode 63 has an opening 63a, the diameter d₁ of which is less than double the diameter d₂ of the single-pole lens 61. This condition is necessary for sufficient shielding of the field in the region of the specimen. Furthermore the diameter d₁ of the opening 63a of the control electrode 63 should be at least half as great as the diameter d₃ of the beam tube 62a. Otherwise the particles emitted from the specimen 8 are not guaranteed to reach the detector 7a disposed above the lens arrangement 6.

Two further embodiments of single-pole lenses 61', 61'' are shown in Figure 3. The embodiment on the right shows a single-pole magnetic lens 61' with an outer pole piece 61'c which is at least partially conical. In the single-pole lens 61'' shown in the left-hand side the outer pole piece has been removed entirely.

The charged particle beam device according to the invention is designed particularly for the low voltage range, i.e. for final beam energies lower than 5 keV, preferably between 0.5 and 2.5 keV. A particularly suitable source for this purpose is a so-called field emission source or other sources with an energy width of less than 1 eV, for example thermal field emission sources or photo cathodes. With the combination according to the invention of an electrostatic lens with a single-pole lens particularly great working distances can be achieved for the low voltage range with good resolving and imaging properties. Thus in particular specimen holders can also be used which have contacting means protruding above the specimen.

## Claims

1. Electrostatic-magnetic lens arrangement for focusing charged particles with a magnetic single-pole lens (61, 61', 62") and an eletrostatic lens (62) situated within the magnetic lens,
characterised in that the electrostatic lens (62) generates a rotationally symmetrical electrical field and has at least two electrodes (62a, 61b) which can be held at different potentials such that the charged particles are decelerated in the field of the electrostatic lens from a first energy to a lower second energy, and
further characterised by an additional control electrode (63) which is situated in the beam path between the electrostatic lens and a specimen (8) and can be connected to a variable potential for adjustment of the electrical field strength in the region of the specimen.

2. Lens arrangement as claimed in Claim 1, characterised in that one of the two electrodes of the electrostatic lens is constructed as a beam tube (62a).

3. Lens arrangement as claimed in Claim 2, characterised in that the beam tube (62a) is made from non-conductive material which is provided with a thin conductive coating.

4. Lens arrangement as claimed in Claim 2, characterised in that the beam tube (62a) is situated concentrically in an internal bore (61a) of the single-pole lens (61).

5. Lens arrangement as claimed in Claim 1, characterised in that the single-pole lens (61) has an internal bore (61a) and the control electrode (63) has an opening (63a), the diameter (d₁) of the control electrode (53) being less than double the diameter (d₂) of the single-pole lens (61).

6. Lens arrangement as claimed in Claim 1, characterised in that the single-pole lens (61) has an inner and an outer pole piece (61b, 61'c), the outer pole piece (61'c) being at least partially conical in shape.

7. Lens arrangement as claimed in Claim 2, characterised in that the control electrode (63) has an opening (63a) the diameter (d₁) of which is at least half as great as the diameter (d₃) of the beam tube (62a).

8. Charged particle beam device with
a) a source (4) for generating a charged particle beam,
b) an electrostatic-magnetic lens arrangement (6) for focusing the particle beam having a magnetic lens and an electrostatic lens (62) incorporated into the magnetic lens,
c) a deflector arrangement (9) for deflecting the particle beam, and
d) a detector (7) for detecting the secondary and/or back-scattered particles emitted from the specimen (8)
characterised in that the electrostatic-magnetic lens arrangement (6) is constructed as claimed in one of Claims 1 to 7.

9. Charged particle beam device as claimed in Claim 8, characterised in that the electrostatic lens generates a rotationally symmetrical field and has at least two electrodes (62a, 61b) which can be held at different potentials such that the charged particles are decelerated in the field of the electrostatic lens from a first energy to a lower second energy and wherein one of the two electrodes of the electrostatic lens is constructed as a beam tube (62a) which is arranged concentrically in an internal bore (61a) of the single-pole lens (61).

10. Charged particle beam device as claimed in Claim 9, characterised in that the deflector arrangement (9) is situated in the single-pole lens (61) between the wall of the internal bore (61b) and the beam tube (62a).

11. Charged particle beam device as claimed in Claim 8, characterised in that a vacuum facility is provided for generating a vacuum in the region of the particle beam.

12. Charged particle beam device as claimed in Claim 10 and 16, characterised in that a seal (11) is provided between the beam tube (62a) and the single-pole lens (61) such that the deflector arrangement (9) is situated outside the vacuum.

13. Charged particle beam device as claimed in Claim 11, characterised in that the single-pole lens (61) has a field coil (61d) which is shielded from the vacuum by means of a further seal (12) provided on the single-pole lens (61).

14. Charged particle beam device as claimed in Claim 8, characterised in that the detector (7a) is arranged in front of the electrostatic-magnetic lens arrangement (6) in the direction of the particle beam.

15. Charged particle beam device as claimed in Claim 8, characterised in that the detector (7b) is arranged behind the lens arrangement (6) in the direction of the particle beam.

16. Charged particle beam device as claimed in Claim 14 and 20, characterised in that a detector (7a) is provided in front of the lens arrangement and a detector (7b) is provided behind the lens arrangement (8).

17. Charged particle beam device as claimed in one of Claims 8, 14, 15, 16, characterised in that at least one of the detectors (7a, 7b) is divided into segments the output signals of which can be processed separately from one another.

18. Charged particle beam device as claimed in Claim 8, characterised in that a source with an energy width of less than 1 eV is used.

19. Charged particle beam device as claimed in Claim 8 characterised in that at a final beam energy of the charged particles of less than 5 keV, preferably between 0.5 and 2.5 keV, a working distance (a) of more than 5 mm is provided between the lens arrangement and the specimen (8).

20. Charged particle beam device as claimed in Claim 8 characterised in that the distance (a) between the control electrode (63) and the specimen (8) is at least three times the distance (b) between the control electrode (63) and the single pole lens (61).

## Patentansprüche

1. Elektrostatisch-magnetische Linsenanordnung zur Fokussierung geladener Teilchen mit einer magnetischen Einzelpol-Linse (61, 61', 62") und einer innerhalb der Magnetlinse angeordneten elektrostatischen Linse (62),
dadurch gekennzeichnet, daß die elektrostatische Linse (62) ein rotationssymmetrisches, elektrisches Feld erzeugt und mindestens zwei Elektroden (62a, 61b) aufweist, die mit unterschiedlichen Potentialen derart beaufschlagbar sind, daß die geladenen Teilchen im Feld der elektrostatischen Linse von einer ersten auf eine niedrigere zweite Energie abgebremst werden, und
ferner gekennzeichnet durch eine zusätzliche Steuerelektrode 63, die im Strahlengang zwischen elektrostatischer Linse und einer Probe (8) angeordnet ist und mit einem variablen Potential zur Einstellung der elektrischen Feldstärke im Bereich der Probe beaufschlagbar ist.

2. Linsenanordnung nach Anspruch 1, dadurch gekennzeichnet, daß eine der beiden Elektroden der elektrostatischen Linse als Strahlrohr (62a) ausgebildet ist.

3. Linsenanordnung nach Anspruch 2, dadurch gekennzeichnet, daß das Strahlrohr (62a) aus nichtleitendem Material besteht, das mit einer dünnen leitfähigen Schicht versehen ist.

4. Linsenanordnung nach Anspruch 2, dadurch gekennzeichnet, daß das Strahlrohr (62a) konzentrisch in einer Innenbohrung (61a) der Einzelpol-Linse (61) angeordnet ist.

5. Linsenanordnung nach Anspruch 1, dadurch gekennzeichnet, daß die Einzelpol-Linse (61) eine Innenbohrung (61a) und die Steuerelektrode (63) eine Öffnung (63a) aufweist, wobei der Durchmesser (d₁) der Steuerelektrode (63) weniger als der doppelte Durchmesser (d₂) der Einzelpol-Linse (61) beträgt.

6. Linsenanordnung nach Anspruch 1, dadurch gekennzeichnet, daß die Einzelpol-Linse (61) einen inneren und einen äußeren Polschuh (61b, 61'c) aufweist, wobei der äußere Polschuh (61'c) zumindest teilweise konisch ausgebildet ist.

7. Linsenanordnung nach Anspruch 2, dadurch gekennzeichnet, daß die Steuerelektrode (63) eine Öffnung (63a) aufweist, deren Durchmesser (d₁) wenigstens halb so groß wie der Durchmesser (d₃) des Strahlrohres (62a) ist.

8. Korpuskularstrahlgerät mit
a) einer Quelle (4) zur Erzeugung eines Korpuskularstrahls,
b) einer elektrostatisch-magnetischen Linsenanordnung (6) zur Fokussierung des Korpuskularstrahles, die eine Magnetlinse und eine innerhalb der Magnetlinse angeordnete elektrostastische Linse (62) aufweist,
c) einer Ablenkeinrichtung (9) zum Ablenken des Korpuskularstrahls sowie
d) einem Detektor (7) zum Nachweis der auf einer Probe (8) ausgelösten Sekundärkorpuskel bzw. rückgestreuten Korpuskel,
dadurch gekennzeichnet, daß die elektrostatisch-magnetische Linsenanordnung (6) nach einem der Ansprüche 1 bis 7 ausgebildet ist.

9. Korpuskularstrahlgerät nach Anspruch 8, dadurch gekennzeichnet, daß die elektrostatische Linse ein rotationssymmetrisches elektrisches Feld erzeugt und mindestens zwei Elektroden (62a, 61b) aufweist, die mit unterschiedlichen Potentialen derart beaufschlagbar sind, daß die geladenen Teilchen im Feld der elektrostatischen Linse von einer ersten auf eine niedrigere zweite Energie abgebremst werden und wobei die eine der beiden Elektroden der elektrostatischen Linse als Strahlrohr (62a) ausgebildet ist, das konzentrisch in einer Innenbohrung (61a) der Einzelpol-Linse (61) angeordnet ist.

10. Korpuskularstrahlgerät nach Anspruch 9, dadurch gekennzeichnet, daß die Ablenkeinrichtung (9) in der Einzelpol-Linse (61) zwischen der Wandung der Innenbohrung (61b) und dem Strahlrohr (62a) angeordnet ist.

11. Korpuskularstrahlgerät nach Anspruch 8, dadurch gekennzeichnet, daß eine Vakuumeinrichtung zur Erzeugung eines Vakuums im Bereich des Korpuskularstrahls vorgesehen ist.

12. Korpuskularstrahlgerät nach Anspruch 10 und 16, dadurch gekennzeichnet, daß zwischen Strahlrohr (62a) und Einzelpol-Linse (61) eine Dichtung (11) derart vorgesehen ist, daß die Ablenkeinrichtung (9) außerhalb des Vakuums angeordnet ist.

13. Korpuskularstrahlgerät nach Anspruch 11, dadurch gekennzeichnet, daß die Einzelpol-Linse (61) eine Erregerspule (61d) aufweist, die mittels einer weiteren, an der Einzelpol-Linse (61) vorgesehenen Dichtung (12) vom Vakuum abgeschirmt ist.

14. Korpuskularstrahlgerät nach Anspruch 8, dadurch gekennzeichnet, daß der Detektor (7a) in Richtung des Korpuskularstrahles vor der elektrostatisch-magnetischen Linsenanordnung (6) angeordnet ist.

15. Korpuskularstrahlgerät nach Anspruch 8, dadurch gekennzeichnet, daß der Detektor (7b) in Richtung des Korpuskularstrahles nach der Linsenanordnung (6) angeordnet ist.

16. Korpuskularstrahlgerät nach Anspruch 14 und 20, dadurch gekennzeichnet, daß ein Detektor (7a) vor der Linsenanordnung und ein Detektor (7b) nach der Linsenanordnung (6) vorgesehen ist.

17. Korpuskularstrahlgerät nach einem der Ansprüche 8, 14, 15, 16, dadurch gekennzeichnet, daß wenigstens einer der Detektoren (7a, 7b) eine unterteilte Detektionsfläche aufweist, deren Ausgangssignale getrennt voneinander verarbeitbar sind.

18. Korpuskularstrahlgerät nach Anspruch 8, dadurch gekennzeichnet, daß als Quelle eine Feldemissionsquelle vorgesehen ist.

19. Korpuskularstrahlgerät nach Anspruch 8, dadurch gekennzeichnet, daß bei einer End-ernergie der geladenen Teilchen von weniger als 5 keV, vorzugsweise zwischen 0,5 und 2,5 keV, ein Arbeitsabstand (a) von mehr als 5 mm zwischen Linsenanordnung und Probe (8) vorgesehen ist.

20. Korpuskularstrahlgerät nach Anspruch 8, dadurch gekennzeichnet, daß der Abstand (a) zwischen Steuerelektrode (63) und Probe (8) wenigstens das Dreifache des Abstandes (b) zwischen Steuerelektrode (63) und Einzelpol-Linse (61) beträgt.

## Revendications

1. Dispositif de lentille électrostatique-magnétique destiné à focaliser des particules chargées avec une lentille magnétique à pôle unique (61, 61', 61") et une lentille électrostatique (62) située à l'intérieur de la lentille magnétique,
caractérisé en ce que la lentille électrostatique (62) produit un champ électrique à symétrie de révolution, et possède au moins deux électrodes (62a, 61b) qui peuvent être tenues à des potentiels différents de telle façon que les particules chargées sont décélérées dans le champ de la lentille électrostatique depuis une première énergie jusqu'à une deuxième énergie plus faible, et
caractérisé en outre par une électrode de commande additionnelle (63) qui est située sur le trajet du rayonnement entre la lentille électrostatique et un spécimen (8), et qui peut être connectée à un potentiel variable pour ajuster l'intensité du champ électrique dans la région du spécimen.

2. Dispositif de lentille selon la revendication 1, caractérisé en ce que l'une des deux électrodes de la lentille électrostatique est construite sous forme d'un tube à faisceau (62a).

3. Dispositif de lentille selon la revendication 2, caractérisé en ce que le tube à faisceau (62a) est réalisé en un matériau non-conducteur pourvu d'un mince revêtement conducteur.

4. Dispositif de lentille selon la revendication 2, caractérisé en ce que le tube à faisceau (62a) est situé concentriquement dans un perçage interne (61 a) de la lentille à pôle unique (61).

5. Dispositif de lentille selon la revendication 1, caractérisé en ce que la lentille à pôle unique (61) possède un perçage interne (61a), et en ce que l'électrode de commande (63) possède une ouverture (63a), le diamètre (d₁) de l'électrode de commande (53) étant inférieur au double du diamètre (d₂) de la lentille à pôle unique (61).

6. Dispositif de lentille selon la revendication 1, caractérisé en ce que la lentille à pôle unique (61) comporte une pièce polaire intérieure et une pièce polaire extérieure (61b, 61'c), la pièce polaire extérieure (61'c) étant de forme au moins partiellement conique.

7. Dispositif de lentille selon la revendication 2, caractérisé en ce que l'électrode de commande (63) présente une ouverture (63a) dont le diamètre (d₁) est au moins la moitié du diamètre (d₃) du tube à faisceau (62a).

8. Dispositif à faisceau de particules chargées, comprenant :
a) une source (4) pour produire un faisceau de particules chargées,
b) un dispositif de lentille électrostatique-magnétique (6) pour focaliser le faisceau de particules, comprenant une lentille magnétique et une lentille électrostatique (62) incorporée dans la lentille magnétique,
c) un dispositif déflecteur (9) pour défléchir le faisceau de particules, et
d) un détecteur (7) pour détecter les particules secondaires et/ou les particules diffractées en retour émises depuis le spécimen (8),
caractérisé en ce que le dispositif de lentille électrostatique-magnétique (6) est réalisé de la manière revendiquée dans l'une des revendications 1 à 7.

9. Dispositif à faisceau de particules chargées selon la revendication 8, caractérisé en ce que la lentille électrostatique engendre un champ à symétrie de révolution, et comporte au moins deux électrodes (62a, 61b) qui peuvent être maintenues à des potentiels différents, de façon que les particules chargées sont décélérées dans le champ de la lentille électrostatique depuis une première énergie jusqu'à une deuxième énergie plus faible, et dans lequel l'une des deux électrodes de la lentille électrostatique est construite sous forme d'un tube à faisceau (62a) agencé concentriquement dans un perçage interne (6 la) de la lentille à pôle unique (61).

10. Dispositif à faisceau de particules chargées selon la revendication 9, caractérisé en ce que l'agencement déflecteur (9) est situé dans la lentille à pôle unique (61) entre la paroi du perçage interne (61b) et le tube à faisceau (62a).

11. Dispositif à faisceau de particules chargées selon la revendication 8, caractérisé en ce qu'une unité à vide est prévue pour produire un vide dans la région du faisceau de particules.

12. Dispositif à faisceau de particules chargées selon les revendications 10 et 11, caractérisé en ce qu'il est prévu un joint (11) entre le tube à faisceau (62a) et la lentille à pôle unique (61), de sorte que l'agencement déflecteur (9) est situé à l'extérieur du vide.

13. Dispositif à faisceau de particules chargées selon la revendication 11, caractérisé en ce que la lentille à pôle unique (61) comporte un bobinage de champ (61d) isolé vis-à-vis du vide au moyen d'un autre joint (12) prévu sur la lentille à pôle unique (61).

14. Dispositif à faisceau de particules chargées selon la revendication 8, caractérisé en ce que le détecteur (7a) est agencé en face du dispositif de lentille électrostatique-magnétique (6) dans la direction du faisceau de particules.

15. Dispositif à faisceau de particules chargées selon la revendication 8, caractérisé en ce que le détecteur (7b) est agencé derrière le dispositif de lentille (6) dans la direction du faisceau de particules.

16. Dispositif à faisceau de particules chargées selon les revendications 14 et 15, caractérisé en ce qu'il est prévu un détecteur (7a) en face du dispositif de lentille, et en ce qu'il est prévu un détecteur (7b) derrière le dispositif de lentille (6).

17. Dispositif à faisceau de particules chargées selon l'une des revendications 8, 14, 15 et 16, caractérisé en ce que l'un au moins des détecteurs (7a, 7b) est divisé en segment, dont les signaux de sortie peuvent être traités indépendamment les uns des autres.

18. Dispositif à faisceau de particules chargées selon la revendication 8, caractérisé en ce que l'on utilise une source avec une bande d'énergie inférieure à 1 eV.

19. Dispositif à faisceau de particules chargées selon la revendication 8, caractérisé en ce que pour une énergie finale du faisceau de particules chargées inférieure à 5 keV, de préférence entre 0,5 et 2,5 keV, il existe une distance de travail (a) supérieure à 5 mm entre le dispositif de lentille et le spécimen (8).

20. Dispositif à faisceau de particules chargées selon la revendication 8, caractérisé en ce que la distance (a) entre l'électrode de commande (63) et le spécimen (8) est au moins trois fois la distance (b) entre l'électrode de commande (63) et la lentille à pôle unique (61).
